# EUROPEAN PATENT APPLICATION

(11) **EP 2 472 583 A2**
(43) Date of publication of application: **04.07.2012**
(21) Application number: 11193230.7
(22) Date of filing: 13.12.2011
(51) Int. Cl.: H01L 27/32

(54) **Organic light emitting diode display device having a two-sided substrate and method of forming the same**

(30) Priority: 29.12.2010 US 980461
(71) Applicant: Delphi Technologies, Inc., Troy, MI 48007 (US)
(72) Inventor: Kuhlman, Frederick F., Kokomo, IN Indiana 46902 (US); Harbach, Andrew P., Argyle, TX Texas 76226 (US); Sarma, Dwadasi H.R., Kokomo, IN Indiana 46902 (US)
(74) Representative: Denton, Michael John

(57) **Abstract**

A display device (10) built on an insulating substrate (12) suitable for processing on both sides that includes a plurality of conductive through-holes (20) through the substrate (12). One side is reserved for a high-density array (14) of organic light emitting diodes (OLEDs). The OLEDs can be high-density because the electrical connections for the OLEDs are on the other side of the substrate (12) and interconnected via the conductive through-holes (20). The cathode sides (26) of the OLEDs are interconnected by a light transmitting layer (28) overlaying the cathode side that is electrical conductive. On the side of the substrate (12) opposite the OLEDs is an array of anode contacts (32) configured to form an electrical contact with a driver circuit (34).

## Description

### TECHNICAL FIELD

The invention generally relates to an image display system and method of forming the same, and more particularly relates to a system that has a high-density array of organic light emitting diodes (OLEDs) on one side of a substrate and electrical connections to the OLEDs from the other side of and through the substrate.

### BACKGROUND OF INVENTION

Some active matrix organic light emitting diode (AMOLED) displays have about 40 percent of the display surface available for active light emissions. The remaining area is occupied by drive circuitry such as thin film transistor (TFT) circuitry and interconnections between the TFT circuitry and the OLEDs. It has been proposed to construct an AMOLED display that buries the TFT circuitry within a monolithic structure between a substrate and the OLEDs. However, such a structure leads to increased manufacturing complexity because of the leveling layers needed to form such a monolithic structure. Also, such a structure also makes difficult or impossible testing of underlying TFT circuitry after the overlying OLEDs are added.

### SUMMARY OF THE INVENTION

In accordance with one embodiment of this invention, a display device is provided. The display device includes an insulating substrate, a high-density array of organic light emitting diodes, a light transmitting layer, and an array of anode contacts. The insulating substrate is configured to define a first side and a second side. The said insulating substrate includes a plurality of conductive through-holes extending between the first side and the second side. The high-density array of organic light emitting diodes overlays the first side. Each organic light emitting diode is configured to define an anode side that overlays and is electrically connected to one or more of the conductive through-holes, and is configured to define a cathode side opposite the anode side. The light transmitting layer overlays the cathode side and is configured to electrically interconnect each cathode side of the organic light emitting diodes. The array of anode contacts is arranged on the second side. Each anode contact is electrically connected to an anode side via a conductive through-hole, and the anode contacts are configured to form an electrical contact with a driver circuit.

In another embodiment of the present invention, a method of forming a display device is provided. The display device includes an insulating substrate configured to define a first side and a second side. The insulating substrate includes a plurality of conductive through-holes extending between the first side and the second side. The method includes the step of applying a high-density array of organic light emitting diodes on the first side. Each organic light emitting diode has an anode side that overlies and is electrically connected to one or more of the conductive through-holes, and each has a cathode side opposite the anode side. The method also includes the step of applying a light transmitting layer to the cathode side that electrically interconnects each cathode side of the organic light emitting diodes. The method also includes the step of applying an array of anode contacts arranged on the second side. Each anode contact is electrically connected to an anode side via a conductive through-hole, and the anode contacts are configured to form an electrical contact with a driver circuit.

Further features and advantages of the invention will appear more clearly on a reading of the following detailed description of the preferred embodiment of the invention, which is given by way of non-limiting example only and with reference to the accompanying drawings.

### BRIEF DESCRIPTION OF DRAWINGS

The present invention will now be described, by way of example with reference to the accompanying drawings, in which:

Fig. 1 is sectional side view of a display device in accordance with one embodiment;

Fig. 2 is a top view of the display device of Fig. 1 in accordance with one embodiment; and

Fig. 3 is a flow chart of a method for forming the display device of Fig. 1 in accordance with one embodiment.

### DESCRIPTION OF THE PREFERED EMBODIMENT

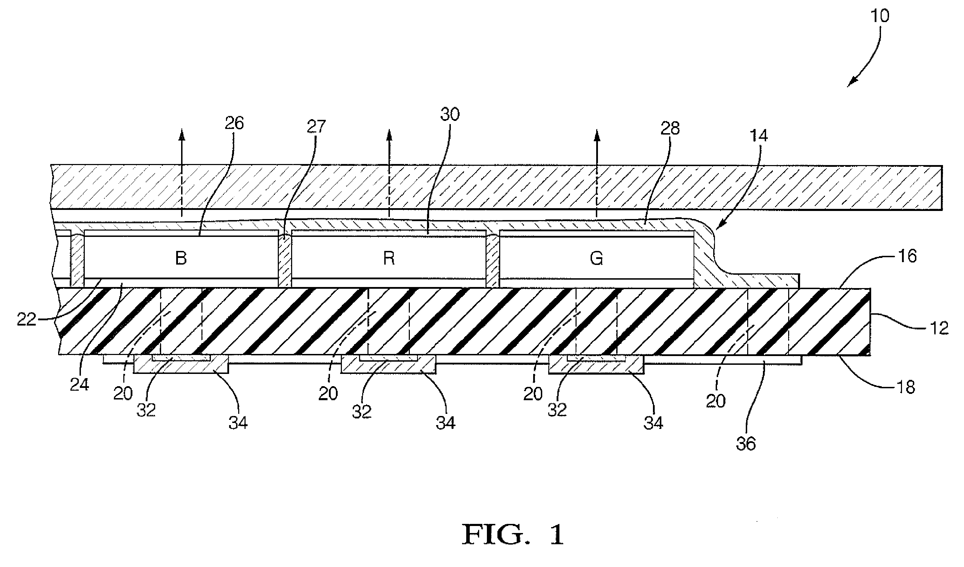

Arrays of organic light emitting diodes (OLEDs) are used to display images in display devices such as personal video displays, cell phone displays, computer displays, and automotive dash displays. In accordance with an embodiment, Fig. 1 illustrates a side cut-away view of a non-limiting example of a display device 10. The display device 10 illustrated includes an insulating substrate 12 supporting a high-density array of OLEDs 14, hereafter often array 14 or high-density array 14, on a first side 16 of the substrate 12. As used herein, high-density means that the array 14 of OLEDs occupies most or all of the space available on the first side 16 between each OLED. In particular, the OLEDs forming the array 14 occupy so much of the first side 16 that there is insufficient space to place other electrical devices on the first side 16 such as transistors or other electrical components, or individual conductor traces to each OLED routed between the OLEDs. Such a high-density array advantageously provides room for larger OLEDs and so provides a brighter display than is possible for similar resolution displays that include on the first side 16 (i.e. the display surface) both OLEDs and other electrical components or conductors. Alternatively, such a display may use pixel sizes comparable to known displays and so provide higher resolution or higher definition displays than is possible with displays that share space on the display surface between OLEDs and other electrical components or conductors.

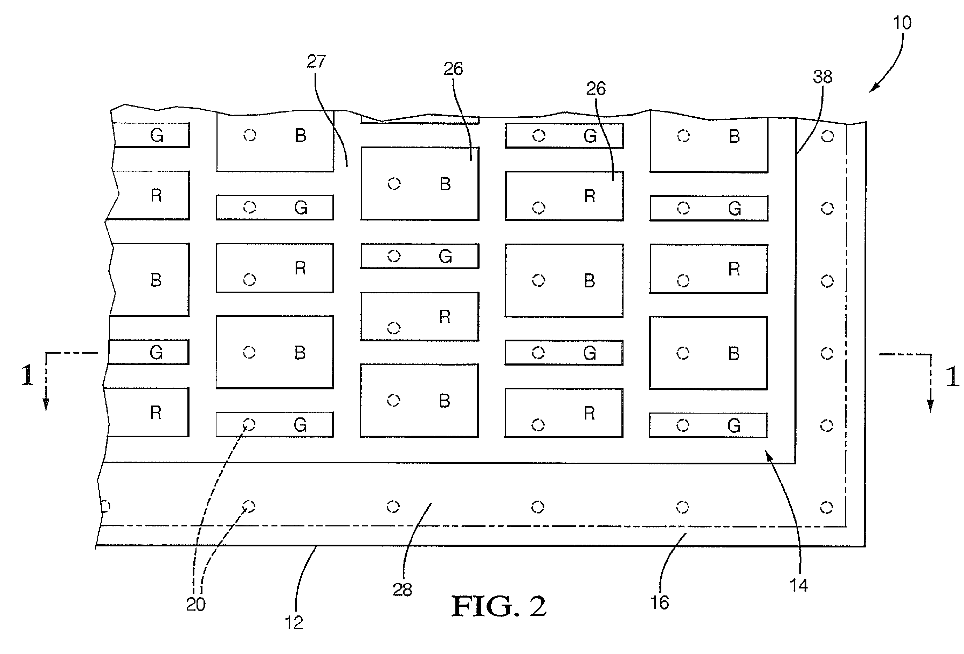

Fig. 2 illustrates a top view of the display device 10 as viewed from the first side 16 and corresponding to the display device illustrated in Fig. 1. The array 14 generally includes red OLEDs R, green OLEDs G, and blue OLEDs B, as illustrated in Figs 1 and 2. It should be understood that Figs. 1 and 2 are illustrations of only a portion of a complete display device, and that complete display devices may have arrays that have over a million OLEDs. The pattern of the array 14 illustrated is for the purpose of explanation and not limitation.

The insulating substrate 12 is generally configured to define a first side 16 and a second side 18. In one embodiment, the insulating substrate 12 may be formed of a polymeric compound such as polyethylene terephthalate (PET), polyethylene naphthalate (PEN) or polyimide (PI). A non-limiting example thickness for the substrate 12 is 0.1 to 0.2 millimeter (mm). The insulating

substrate 12 may include a plurality of vias or conductive through-holes 20 extending through the substrate 12 between the first side 16 and the second side 18. By selecting a material suitable for processing from both sides, the density of the array 14 can be maximized as will be explained in more detail below. A non-limiting example diameter for a conductive through-hole through a substrate having a thickness in the range suggested above is 0.04 mm. Holes may be machined through the substrate 12 using a number of known processes, for example laser drilling. The holes may become the conductive through-holes 20 by a number of known processes, for example chemical plating. The substrate 12 is illustrated as being flat, but it should be recognized that the substrate may be bent or otherwise formed into a non-flat shape prior to or during subsequent processing. Forming non-flat displays may be particularly useful for manufacturing automotive dash displays as non-flat displays are considered to be less susceptible to being obscured by the display reflecting ambient light sources such as sun-light. Also, some vehicle designers prefer the styling possibilities offered by non-flat displays.

The arrangement of conductive through-holes 20 is preferably such that each OLED of the array 14 overlays at least one of the conductive through-holes 20 and makes electrical contact with the conductive through-hole that it overlays. In one embodiment each OLED has an anode side 22 overlying and electrically connected to one or more of the conductive through-holes, and has a cathode side 26 opposite the anode side. Forming an electrical connection between the anode side 22 and the corresponding conductive through-hole 20 may include forming an annular ring on the first side 16 using known chemical plating and photo processing techniques. Known additional materials necessary to form an electrical connection between the anode side 22 of an OLED and a conductive through-hole are generally illustrated as an anode side interface layer 24. The anode side interface layer may be formed at the same time the conductive through-holes 20 are formed, and may or may not extend beyond the diameter of the conductive through-hole. Fig. 1 illustrates the anode side interface layer 24 as extending beyond the diameter of the conductive through-hole 20, but this is only for the purpose of explanation and not limitation. The arrangement may also include a boundary region 27 to electrically isolate adjacent OLEDs.

The display device 10 may also include a light transmitting layer 28 overlaying the cathode side and configured to electrically interconnect each cathode side 26 of the array 14 of the OLEDs. In one embodiment the light transmitting layer is formed of an Indium/Titanium/Oxide compound, commonly known as ITO, that is both light transmitting and electrically conductive. Other materials that can form a layer that is both light transmitting and electrically conductive may be available, but may require that a cathode side interface layer 30 be provided to assure the electrical connection between the cathode side 26 and the light transmitting layer 28. By such an arrangement, all of the cathodes of all of the OLEDs forming the array 14 may be electrically biased to the same voltage potential by way of a single electrical connection, for example biased to a ground potential.

The display device 10 may also include an arrangement or array of anode contacts 32 arranged on the second side 18. Each anode contact 32 is electrically connected to an anode side 22 via one or more of the conductive through-holes 20. Like the anode side interface layer 24 described above, the anode contact 32 is illustrated as extending beyond the diameter of the conductive through-hole 20 for the purpose of explanation and not limitation. In general, anode contacts 32 are configured to form an electrical contact with the driver circuit 34 attached or applied to the display device 10, for example a driver circuit that includes a thin film transistor. The display device 10 may also include a conductor layer 36 disposed on the second side to electrically interconnect the drive circuit 34 with another drive circuit or a controller (not shown) providing control signals to the drive circuit 34. It should be understood that the conductor layer 36 may be formed of many individual conductor traces, and may include multiple layers of conductor traces, for example row and column traces so the OLEDs can be individually controlled to form an image on the display device 10, and or power and ground planes for distributing electrical power across the second side 18 of the display device 10.

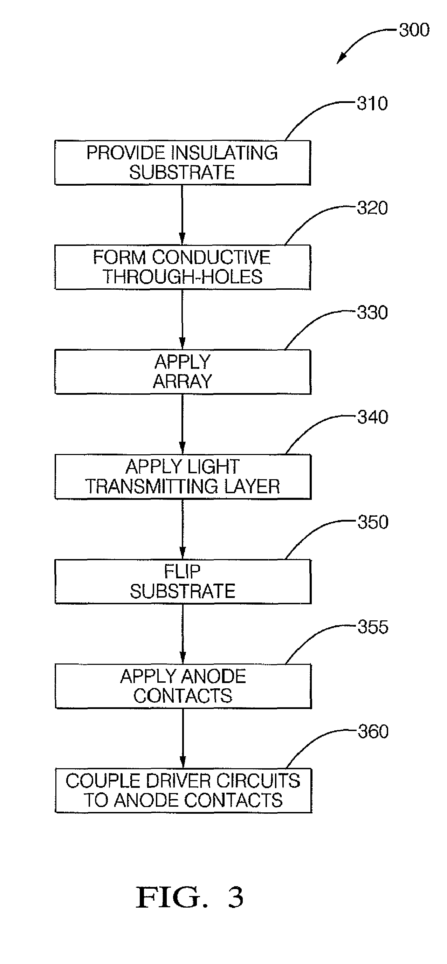

In general, a biasing voltage for the cathode side 26 is coupled through the light transmitting layer 28. In one embodiment the high-density array 14 may be configured to define a perimeter 38, illustrated in Fig. 2 as a line surrounding the high-density array 14. In this embodiment, the insulating substrate 12 may include conductive through-holes 20 located outside the perimeter 38 relative to the OLEDs within the perimeter 38. The light transmitting layer 28 may make electrical contact with a conductive through-hole 20 located outside the perimeter 38, and so can make electrical contact with the conductor layer 36 on the second side 18. As such, electrical contact with the conductor layer 36 may also make contact with a driver circuit 34, and so the driver circuit 34 makes electrical contact with a cathode side 26 via the conductive through-holes 20 outside the perimeter 38. The example pixel pattern suggested in Fig. 3 has sub-pixel area ratios for the R, B, an G sub-pixel that conveniently lend themselves to a pixel pattern that occupies all of the area within the perimeter. However, if the sub-pixel area ratios are such that unused space on the first side between the subpixels is unavoidable, or if desired, the electrical connection between the light transmitting layer 28 and the second side 18 may be provided by conductive through-holes 20 distributed within the perimeter 38 that are not under or electrically connected to any of the OLEDs.

Fig. 1 further illustrates that the display device 10 may also include a protective cover to protect the underlying assembly. The protective cover may be separated from the underlying assembly as illustrated, or may be in contact with the underlying assembly.

Fig. 3 illustrates a method 300 of forming a display device 10. The order of the steps illustrated in Fig. 3 and discussed below is exemplary and non-limiting, and those skilled in the art will recognize that the steps could be reordered and other steps added to form the display device 10.

Step 310, PROVIDE INSULATING SUBSTRATE, may include providing an insulating substrate 12 that is configured to define a first side 16 and a second side 18. The substrate is preferably formed of a material suitable for adding an array 14 of organic light emitting diodes (OLEDs) as set forth below. For example the substrate 12 may be formed of a polymeric film or organic film material.

Step 320, FORM CONDUCTIVE THROUGH-HOLES, may include forming a plurality of conductive through-holes 20 extending between the first side 16 and the second side 18 by laser drilling, mechanical drilling, or other known processes for forming holes in the substrate 12.

Step 330, APPLY ARRAY, may include applying a high-density array 14 of OLEDs on the first side 16, wherein each OLED has an anode side 22 overlying and electrically connecting to one or more of the conductive through-holes 20, and has a cathode side 26 opposite the anode side 22. Processes for forming OLEDs on polymeric or organic substrates are described in WO2007/092541 published August 16, 2007 by Roehrig et al., and US2006/121816 published June 8, 2006 by Lee et al., the entire contents of which are hereby incorporated by reference herein. The step of applying a high-density array 14 of OLEDs may also include depositing a boundary region 27 of material suitable to electrically insulate anode side interface layers 24 of adjacent OLEDs from each other. In particular, the boundary region 27 protects these anode side interface layers 24 from contacting the light transmitting layer 28 and so prevents electrically connecting all the anode contacts 32 together by way of shorting the anode side interface layers 24 together.

Step 340, APPLY LIGHT TRANSMITTING LAYER, may include applying a light transmitting layer 28 to the cathode side 26 that electrically interconnects each cathode side 26 of the organic light emitting diodes. ITO is a suitable material to use for the light transmitting layer 28. This step may also include applying the light transmitting layer 28 to the first side 16 outside a perimeter 38 defined by and surrounding the high density array 14 such that the cathode side 26 makes electrical contact with a conductive through-hole 20 located outside the perimeter 38.

Step 350, FLIP SUBSTRATE, may include flipping the substrate 12 over so further processing may be performed on the second side 18. As such, this step may optionally be performed following steps 330 and 340, and before step 360. Flipping the substrate 12 may be preformed elsewhere during the manufacturing process described in method 300, and may be performed more than once, particularly if the order of the steps is changed.

Step 360, APPLY ANODE CONTACTS, may include applying an array of anode contacts 32 arranged on the second side 18, wherein each anode contact 32 is electrically connected to an anode side 22 via a conductive through-hole 20, and the anode contacts 32 are configured to form an electrical contact with a driver circuit 34 if one is subsequently attached or applied to the second side 18.

Step 370, COUPLE DRIVER CIRCUIT TO ANODE CONTACTS, may include coupling a driver circuit 34 to the array of anode contacts 32 using any of a number of know techniques. For example, the driver circuit 34 may include a thin film transistor (TFT), and so the TFT may be coupled to the anode contacts 32 using known processes for applying the TFT to a surface such as the second side 18.

Accordingly, a display device 10, and a method 300 of forming the display device 10 is provided. By placing all or most of the drive circuit 34 and conductor layer 36 on an opposite side of a two-sided substrate as an array of OLEDs, the array can be a high-density array 14 that maximizes the amount of the area available for generating light and so maximizes the brightness of the display device 10 and/or increases the resolution of the display device 10. By configuring the display device so drive circuitry can be added after the high-density array 14 is formed, testing of the OLEDs can be performed before adding the drive circuitry, and the drive circuitry can be easily tested after being added since it is exposed on the opposite side. The drive circuitry may be applied to the opposite side using known techniques for applying thin film transistor TFT circuitry, or the drive circuitry may be a separate part that is package for convenient attachment to the second side, for example a surface mount type package attached to the second side using solder or conductive epoxy. The skilled practitioner will recognize that the arrangement set forth herein will lend itself to constructing double sided OLEDs.

## Claims

1. A display device (10) comprising:
an insulating substrate (12) configured to define a first side (16) and a second side (18), said insulating substrate (12) comprising a plurality of conductive through-holes (20) extending between the first side and the second side;
a high-density array (14) of organic light emitting diodes overlaying the first side, wherein each organic light emitting diode is configured to define an anode side (22) overlying and electrically connected to one or more of the conductive through-holes (20), and define a cathode side (26) opposite the anode side;
a light transmitting layer (28) overlaying the cathode side and configured to electrically interconnect each cathode side of the organic light emitting diodes; and
an array of anode contacts (32) arranged on the second side, wherein each anode contact (32) is electrically connected to an anode side via a conductive through-hole (20), and the anode contacts (32) are configured to form an electrical contact with a driver circuit (34).

2. The display device (10) in accordance with claim 1, wherein the insulating substrate (12) is formed of a polymeric compound.

3. The display device (10) in accordance with claim 1, wherein the high density array (14) is configured to define a perimeter (38) surrounding the high density array (14), the insulating substrate (12) has conductive through-holes (20) located outside the perimeter (38), the light transmitting layer (28) makes electrical contact with a conductive through-hole (20) located outside the perimeter (38), and the driver circuit (34) makes electrical contact with a cathode side (26) via the conductive through-holes (20) outside the perimeter (38).

4. The display device (10) in accordance with claim 1, wherein the driver circuit (34) includes a thin film transistor.

5. A method (300) of forming a display device (10) comprising an insulating substrate (12) configured to define a first side (16) and a second side (18), said insulating substrate (12) comprising a plurality of conductive through-holes (20) extending between the first side and the second side, said method (300) comprising the steps of:
applying (330) a high-density array (14) of organic light emitting diodes on the first side, wherein each organic light emitting diode has an anode side (22) overlying and electrically connecting to one or more of the conductive through-holes (20), and has a cathode side (26) opposite the anode side;
applying (340) a light transmitting layer (28) to the cathode side that electrically interconnects each cathode side of the organic light emitting diodes; and
applying (355) an array of anode contacts (32) arranged on the second side, wherein each anode contact (32) is electrically connected to an anode side via a conductive through-hole (20), and the anode contacts (32) are configured to form an electrical contact with a driver circuit (34).

6. The method (300) in accordance with claim 5, wherein the step (340) of applying a light transmitting layer (28) includes applying the light transmitting layer (28) to the first side (16) outside a perimeter (38) surrounding the high density array (14) such that the cathode side (26) makes electrical contact with a conductive through-hole (20) located outside the perimeter (38).

7. The method (300) in accordance with claim 5, wherein the method (300) includes the step of coupling (360) a driver circuit (34) to the array of anode contacts (32).

8. The method (300) in accordance with claim 7, wherein the step (360) of coupling a driver circuit (34) to the array of anode contacts (32) includes applying a thin film transistor to the second side (18).

9. The method (300) in accordance with claim 5, wherein the method (300) includes the step flipping (350) the substrate (12) following the steps of applying (330) the high-density array (14) of organic light emitting diodes and applying (340) the light transmitting layer (28), and before the step of applying (355) the array of anode contacts (32).
